Europäisches Patentamt

European Patent Office

Office européen des brevets

(11) Veröffentlichungsnummer: **0 037 115**
**B1**

## EUROPÄISCHE PATENTSCHRIFT

(45) Veröffentlichungstag der Patentschrift: 07.08.85

(51) Int. Cl.⁴: **H 01 L 29/78**

(21) Anmeldenummer: 81102396.9

(22) Anmeldetag: 30.03.81

(54) **Planare Halbleiteranordnung mit erhöhter Durchbruchsspannung.**

(30) Priorität: 31.03.80 DE 3012430

(43) Veröffentlichungstag der Anmeldung:
07.10.81 Patentblatt 81/40

(45) Bekanntmachung des Hinweises auf die
Patenterteilung:
07.08.85 Patentblatt 85/32

(84) Benannte Vertragsstaaten:
CH DE FR GB IT LI SE

(56) Entgegenhaltungen:
DE-A-2 706 623
US-A-4 041 519
US-H-t 964 009

(73) Patentinhaber: **Siemens Aktiengesellschaft**
**Berlin und München Wittelsbacherplatz 2**
**D-8000 München 2 (DE)**

(72) Erfinder: **Ladenhauf, Wilhelm, Ing. grad.**
**Adenauer Strasse 20**
**D-8031 Puchheim (DE)**
Erfinder: **Leipold, Ludwig, Dipl.-Ing.**
**Kurt-Eisner-Strasse 41**
**D-8000 München 83 (DE)**
Erfinder: **Stengl, Jens Peer, Ing. grad.**
**Guntherstrasse 13/III**
**D-8000 München 19 (DE)**
Erfinder: **Tihanyi, Jenö, Dr.**
**Wolfratshauser Strasse 179 b**
**D-8000 München 71 (DE)**

Courier Press, Leamington Spa, England.

**Beschreibung**

Die Erfindung bezieht sich auf eine Halbleiteranordnung mit einem Substrat vom ersten Leitfähigkeitstyp, mit einer Vielzahl von Zellen mit jeweils einer ersten Zone vom zweiten Leitfähigkeitstyp, die planar in das Substrat eingebettet ist, mit jeweils einer zweiten Zone vom ersten Leitfähigkeitstyp, die planar in die erste Zone eingebettet ist, wobei in der ertsen Zone eine Kanalzone liegt, die an der Substratoberfläche das Substrat und die zweite Zone verbindet, mit einer auf der Substratoberfläche angeordneten Isolierschicht, auf der eine mindestens die Kanalzone überdeckende Steuerelektrode angebracht ist.

Eine Halbleiteranordnung dieser Art, zum Beispiel ein MIS-Feldeffekttransistor (FET), ist bereits beschrieben worden. Bei einem solchen FET und auch bei anderen Halbleiteranordnungen der angegebenen Gattung, zum Beispiel bei Thyristoren oder bei integrierten Schaltkreisen, ist bei Anlegen einer Spannung in Durchlaßrichtung der zwischen erster Zone und Substrat liegende pn-Übergang in Sperrichtung vorgespannt. Aufgrund der durch die Anwendung der Planartechnik vorhandenen Krümmung der Raumladungszone zwischen der ersten Zone und dem Substrat kommt es an den Krümmungen zu Feldstärkeerhöhungen an der Oberfläche, die zu einem Steilanstieg des Transistorstroms führen. Dieser Steilanstieg liegt unter demjenigen Spannungswert, bei dem der Steilanstieg im Substrat eintreten würde, der im wesentlichen durch die Eigenschaften des Halbleitermaterials bestimmt ist. Zur Lösung dieses Problems müßte also die Krümmung der Raumladungszone vermindert werden.

Bekannte Maßnahmen bestanden zum Beispiel darin, zwischen dem pn-Übergang der dem Rand benachbarten Zellen und dem Rand der Halbleiteranordnung einen auf schwimmendem Potential liegenden Schutzring anzuordnen, der aus einer Zone vom dem Substrat entgegengesetzten Leitfähigkeitstyp besteht. Ein oder mehrere solcher Schutzringe benötigen jedoch relativ viel Platz auf dem Substrat, der dann nicht mehr als aktive, stromführende Fläche zur Verfügung steht.

Der Einfindung liegt die Aufgabe zugrunde, eine Halbleiteranordnung der eingangs erwähnten Gattung so weiterzubilden, daß eine Erhöhung der Durchbruchsspannung durch Verringerung der Krümmung der Raumladungszone auch mit weniger Platzaufwand möglich ist.

Die Erfindung ist dadurch gekennzeichnet, daß zwischen der ersten Zone der dem Rand der Halbleiteranordnung benachbarten Zellen und dem Rand der Halbleiteranordnung jeweils mindestens eine gegen die Substratoberfläche isolierte Hilfselektrode vorgesehen ist, daß die Hilfselektrode mehrere Abschnitte aufweist und daß der näher am Rand der Halbleiteranordnung liegende Abschnitt einen größeren Abstand zur Substratoberfläche einnimmt als der näher an der ersten Zone liegende Abschnitt. Weiterbildungen der Erfindung sind Gegenstand der Unteransprüche.

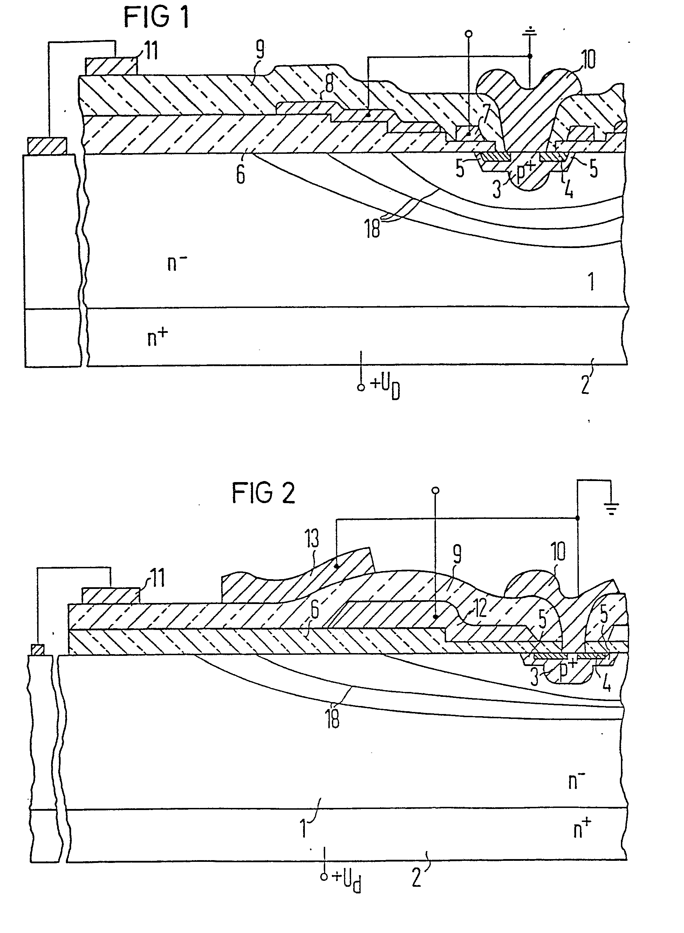

Die Erfindung wird anhand zweier Ausführungsbeispiele in Verbindung mit den Figuren näher erläutert. Die Fig. 1 bis 3 zeigen Schnitte durch drei verschiedene Ausführungsbeispiele eines FET zwischen einer dem Rand benachbarten Zelle und dem Rand. Gleiche oder funktionsgleiche Teile sind in den Figuren mit gleichen Bezugszeichen versehen.

Der FET nach Fig. 1 weist ein Substrat 1 auf, das beispielsweise schwach n-dotiert ist. Es ist an der Unterseite mit einer stark n-dotierten Schicht 2 versehen, die die Senke (Drain) eines FET darstellt. In das Substrat 1 ist eine erste Zone 3 entgegengesetzten Leitfähigkeitstyps planar eingebettet. Diese hat eine höhere Dotierungskonzentration als das Substrat, ist also stark p-dotiert. In die erste Zone 3 ist eine zweite Zone 4 vom ersten Leitfähigkeitstyp eingebettet, die als Quelle (Source) dient. Diese Zone ist ebenfalls hochdotiert, also stark n-dotiert. Zwischen der zweiten Zone 4 und dem Substrat liegt eine Kanalzone 5, die Bestandteil der ersten Zone 3 ist. Die Kanalzone 5 ist durch Ionenimplantation hergestellt, während der tief in das Substrat eindringende Teil der Zone 3 eindiffundiert ist. Die zweite Zone 4 wird zweckmäßigerweise ebenfalls durch Ionenimplantation hergestellt.

Die Oberfläche des Substrats ist mit einer ersten Isolierschicht 6 bedeckt, die beispielsweise aus Siliciumdioxid $SiO_2$ bestehen kann. Diese Schicht 6 weist Stufen auf, wodurch sie von der ersten Zone ausgehend in Richtung des Substratrandes eine zunehmende Dicke erhält. Auf der Isolierschicht 6 ist einer Hilfselektrode 8 angeordnet. Der Abstand zwischen Hilfselektrode 8 und Substratoberfläche wächst daher mit zunehmendem Abstand von der ersten Zone 3. Die Hilfselektrode 8 liegt an einer Hilfsspannung, zum Beispiel auf Source-Potential. Der dünnste Teil der Schicht 6 ist das Gateoxid. Es überdeckt die zweite Zone 4, die Kanalzone 5 und einen Teil des Substrats. Auf dem Gateoxid ist eine Steuerelektrode 7 angeordnet, die zum Beispiel aus hochdotiertem n-leitendem polykristallinem Silicium besteht. Diese Steuerelektrode bedeckt die Kanalzone 5, überlappt die zweite Zone 4 und das Substrat 1. Die Isolierschicht 6 ist mit einer Passivierungsschicht 9 bedeckt, die beispielsweise aus einem Oxid eines Siliciums bestehen kann, das aus der Dampfphase oder aus einem Plasma auf der Oberfläche der Schicht 6 beziehungsweise der Elektrode 8 abgeschieden wurde. Die Schicht 9 kann auch eine Nitridschicht sein.

Die zweite Zone 4 ist durch ein Kontaktlochmittels eines Kontaktes 10 kontaktiert. Dieser kontaktiert gleichzeitig auch die erste Zone 3.

Wird an den FET eine Spannung mit der eingezeichneten Polarität angelegt, so bildet sich beiderseits des pn-Übergangs zwischen der Zone 3 und dem Substrat 1 eine Raumladungszone aus. Diese folgt normalerweise in etwa der Verlauf des pn-Übergangs, ist also insbesondere an der Oberfläche des Substrats stark gekrümmt. Beim Betrieb des Transistors liegt an der Hilfselektrode 8 das Potential der Quelle, während an der Steuerelektrode 7 im Betrieb dauernd ein Potential liegt, das zum Beispiel um 5 V höher ist. Diese positive Steuerspannung schafft eine Inversionsschicht im Kanal 5 und ein Strom beginnt zu fließen. Beide Maßnahmen verursachen einen Ladungsträgerfluß zur Senke, dessen Verlauf durch die Form der Raumladungszone bestimmt ist. Die Äquipotentiallinien der Raumladungszone sind mit 18 bezeichnet. Es ist ersichtlich, daß die Raumladungszone dort einen schwach gekrümmten Verlauf aufweist, wo sie an die Substratoberfläche angrenzt. Die Feldstärke ist daher dort klein. Damit wird eine Multiplikation der durchfließenden Ladungsträger an der Substratoberfläche und an irgendwelchen Krümmungen im Substratinneren bedeutend erschwert. Eine Multiplikation wird daher im wesentlichen nur noch im Substratinneren auftreten und nur noch durch die Materialeigenschaften des Substratmaterials bestimmt sein.

Im Ausführungsbeispiel nach Fig. 2 übernimmt die Steuerelektrode 12 einen Teil der Funktion der Hilfselektrode 8 nach Fig. 1. Sie erstreckt sich über eine Stufe der Isolierschicht 6. Auf der die Steuerelektrode 12 und die erste Isolierschicht 6 bedeckenden zweiten Isolierschicht 9 ist eine Hilfselektrode 13 angeordnet, die elektrisch mit der Quelle verbunden ist. Sie kann die Steuerelektrode überlappen. Die Hilfselektrode 13 hat einen größeren Abstand von der Substratoberfläche als die Steuerelektrode 12. Der Abstand der gesamten Hilfselektrode von der Substratoberfläche wächst also auch hier mit zunehmendem Abstand von der Zone 3.

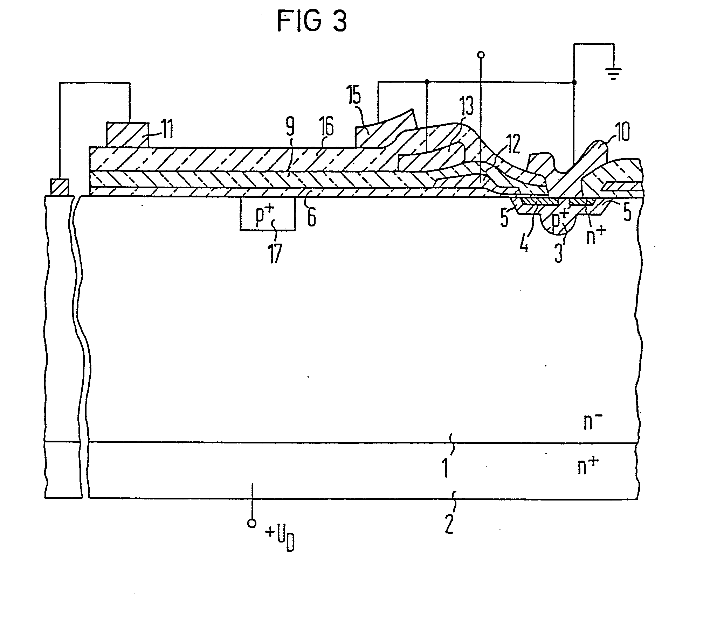

Die Anordnung nach Fig. 3 unterscheidet sich von dem nach Fig. 2 durch einen zusätzlichen weiteren, zur Hilfselektrode gehörenden Abschnitt 15. Zur Unterbringung dieses Abschnitts 15 ist die Elektrode 10 mit einer dritten Isolierschicht 16 zum Beispiel aus einem Nitrid überdeckt. Auf dieser Nitridschicht ist dann der Abschnitt 15 zum Beispiel durch Aufdampfen von Aluminium aufgebracht. Er ist elektrisch mit der Elektrode 13 verbunden. Entsprechend könnte auch hier die Steuerelektrode wie in Fig. 1 für sich getrannt angebracht sein und nur die Kanalzone 5 überdecken und die zweite Zone 4 und das Substrat 1 überlappen. Der die Funktion der Hilfselektrode übernehmende abgetrennte Rest der Steuerelektrode wird dann elektrisch mit der Quelle verbunden.

Eine Abwandlung der Erfindung ist zum Beispiel auch dahingehend möglich, daß die Steuerelektrode alleine die Funktion der Hilfselektrode übernimmt. Die Steuerelektrode der dem Substratrand benachbarten Zellen erstreckt sich dann über eine oder mehrere Stufen und nimmt mit wachsender Entfernung von der Zelle einen größer werdenden Abstand zur Substratoberfläche ein.

Ist zwischen der ersten Zone 3 der dem Rand benachbarten Zelle und dem Substratrand noch genügend Platz vorhanden, so kann zusätzlich im Substrat noch eine Schutzzone 17 vorgesehen sein, die gleichen Leitfähigkeitstyp wie die erste Zone 3 hat. Um bei großen Spannungen ein Aufweiten der Raumladungszone soweit zu verhindern, daß sie an der nicht passivierten Seitenfläche des Substrats mündet, kann auf einer der Isolierschichten noch eine Elektrode 11 angebracht sein, die über einen Kontakt auf das Potential der Substratoberfläche, das heißt praktisch auf das Potential der Senke ($+U_D$) gelegt wird. Dann bildet sich unter der Elektrode 11 eine mit negativen Ladungsträgern hoher Konzentration angereicherte Schicht aus, die die Raumladungszone festhält.

**Patentansprüche**

1. Halbleiteranordnung mit einem Substrat (1) vom ersten Leitfähigkeitstyp, mit einer Vielzahl von Zellen mit jeweils einer ersten Zone (3) vom zweiten Leitfähigkeitstyp, die planar in das Substrat (1) eingebettet ist, mit jeweils einer zweiten Zone (4) vom ersten Leitfähigkeitstyp, die planar in die erste Zone (3) eingebettet ist, wobei in der ersten Zone (3) eine Kanalzone (5) liegt, die an der Substratoberfläche das Substrat (1) und die zweite Zone (4) verbindet, mit einer auf der Substratoberfläche angeordneten Isolierschicht (6), auf der eine mindestens die Kanalzone (5) überdeckende Steuerelektrode (7, 12) angebracht ist, dadurch gekennzeichnet, daß zwischen der ersten Zone (3) der dem Rand der Halbleiteranordnung benachbarten Zellen und dem Rand der Halbleiteranordnung jeweils mindestens eine gegen die Substratoberfläche isolierte Hilfselektrode (8, 12, 13, 15) vorgesehen ist, daß die Hilfselektrode (8, 12, 13, 15) mehrere Abschnitte aufweist und daß der näher am Rand der Halbleiteranordnung liegende Abschnitt einen größeren Abstand zur Substratoberfläche einnimmt als der näher an der ersten Zone (3) liegende Abschnitt.

2. Halbleiteranordnung nach Anspruch 1, dadurch gekennzeichnet, daß die Hilfselektrode (8) auf einer sich stufenweise zum Rand hin verdikkenden Isolierschicht (6) angeordnet ist.

3. Halbleiteranordnung nach Anspruch 1, dadurch gekennzeichnet, daß die Hilfselektrode in mehrere Abschnitte (13, 15) unterteilt ist, die jeweils durch eine Isolierschicht (9, 16) voneinander getrennt sind.

4. Halbleiteranordnung nach Anspruch 3, dadurch gekennzeichnet, daß sich die Abschnitte (13, 15) überlappen.

5. Halbleiteranordnung nach Anspruch 3 oder 4, dadurch gekennzeichnet, daß die Abschnitte (13, 15) elektrisch untereinander verbunden sind.

6. Halbleiteranordnung nach Anspruch 3, 4 oder 4, dadurch gekennzeichnet, daß mindestens der der ersten Zone (3) am nächsten liegende Abschnitt durch die Steuerelektrode (12) gebildet ist.

7. Halbleiteranordnung nach Anspruch 6, dadurch gekennzeichnet, daß die Steuerelektrode (12) auf einer sich stufenweise zum Rand hin verdickenden Isolierschicht angeordnet ist.

8. Halbleiteranordnung nach einem Ansprüche 1 bis 5, dadurch gekennzeichnet, daß die Hilfselektrode elektrisch mit der Quelle verbunden ist.

## Revendications

1. Dispositif à semiconducteurs comportant un substrat (1) possédant le premier type de conductivité, une multiplicité de cellules comportant chacune une première zone (3) possédant le second type de conductivité et qui est insérée selon le mode planar dans le substrat (1), et une seconde zone (4) possédant le premier type de conductivité et qui est insérée selon le mode planar dans la première zone (3), alors que dans la première zone (3) se trouve disposée une zone de canal (5) qui relie le substrat (1) et la seconde zone (4) au niveau de la surface du substrat, et comportant une couche isolante (6) située à la surface du su strat et sur laquelle est disposée une électrode de commande (7,12) recouvrant au moins la zone de canal (5), caractérisé par le fait qu'il est prévu au moins une électrode auxiliaire (8,12,13,15) isolée par rapport à la surface du substrat, entre la première zone (3) des cellules voisines du bord du dispositif à semiconducteurs et le bord de ce dispositif, que l'électrode auxiliaire (8,12,13,15) comporte plusieurs éléments et que l'élément qui est le plus proche du bord du dispositif à semiconducteurs, est plus éloigné de la surface du substrat que l'élément qui est le plus rapproché de la première zone (3).

2. Dispositif à semiconducteurs suivant la revendication 1, caractérisé par le fait que l'électrode auxiliaire (8) est disposée sur une couche isolante (6) s'épaississant de façon étagée en direction du bord.

3. Dispositif à semiconducteurs selon la revendication 1, caractérisé par le fait que l'électrode auxiliaire est subdivisée en plusieurs éléments (13,15) qui sont séparés l'un de l'autre par une couche isolante (9, 16).

4. Dispositif à semiconducteurs selon la revendication 3, caractérisé par le fait que les éléments (13,15) se chevauchent.

5. Dispositif à semiconducteurs suivant la revendication 3 ou 4, caractérisé par le fait que les éléments (13,15) sont reliés électriquement entre eux.

6. Dispositif à semiconducteurs selon la revendication 3, 4 ou 5, caractérisé par le fait qu'au moins l'élément qui est le plus rapproché de la première zone (3), est constitué par l'électrode de commande (12).

7. Dispositif à semiconducteurs suivant la revendication 6, caractérisé par le fait que l'électrode de commande (12) est disposée sur une couche isolante s'épaississant de façon échelonnée en direction du bord.

8. Dispositif à semiconducteurs suivant l'une des revendications 1 à 5, caractérisé par le fait que l'électrode auxiliaire est reliée électriquement à la source.

## Claims

1. A semiconductor arrangement comprising a substrate (1) of the first conductivity type, a plurality of cells, each having a first zone (3) of the second conductivity type which is embedded in planar fashion in the substrate (1), and each having a second zone (4) of the first conductivity type which is embedded in planar fashion in the first zone (3), wherein, in the first zone (3) at the substrate surface, there is arranged a channel zone (5) which connects the substrate (1) and the second zone (4), and an insulating layer (6) arranged on the substrate surface and on which there is arranged a control electrode (7, 12) which covers at least the channel zone (5), characterised in that, between the first zone (3) of those cells which are adjacent to the edge of the semiconductor arrangement and the edge of the semiconductor arrangement, there is arranged at least one auxiliary electrode (8, 12, 13, 5) which is insulated from the substrate surface; that the auxiliary electrode (8, 12, 13, 15) has a plurality of sections; and that the section which is arranged closer to the edge of the semiconductor arrangement is spaced at a greater distance from the surface of the substrate than is the section which is arranged closer to the first zone (3).

2. A semiconductor arrangement as claimed in Claim 1, characterised in that the auxiliary electrode (8) is arranged on an insulating layer (6) which increases in thickness stepwise towards the edge.

3. A semiconductor arrangement as claimed in Claim 1, characterised in that the auxiliary electrode is divided into a plurality of sections (13, 15) which are separated from one another by an insulating layer (9, 16) in each case.

4. A semiconductor arrangement as claimed in Claim 3, characterised in that the sections (13, 15) overlap.

5. A semiconductor arrangement as claimed in Claim 3 or Claim 4, characterised in that the sections (13, 15) are electrically connected to one another.

6. A semiconductor arrangement as claimed in Claim 3, 4 or 5, characterised in that at least that section which is closest to the first zone (3) is formed by the control electrode (12).

7. A semiconductor arrangement as claimed in Claim 6, characterised in that the control electrode (12) is arranged on an insulating layer whose thickness increases stepwise towards the edge.

8. A semiconductor arrangement as claimed in one of Claims 1 to 5, characterised in that the auxiliary electrode is electrically connected to the source.

FIG 1

11
9
8
10
6
5
3 p+ 4 5
18
n⁻
1
n⁺
+U_D
2

FIG 2

13
9
10
11
6
12
5
5
3 p+ 4
18
n⁻
1
n⁺
+U_d
2

1

# FIG 3